# EUROPEAN PATENT APPLICATION

(11) **EP 4 539 628 A1**
(43) Date of publication of application: **16.04.2025**
(21) Application number: 24196646.4
(22) Date of filing: 27.08.2024
(51) Int. Cl.: H10D 30/47, H10D 30/01, H10D 64/27, H10D 62/80

(54) **SEMICONDUCTOR DEVICE AND METHOD OF MANUFACTURING THE SAME**

(30) Priority: 11.10.2023 KR 20230135404
(71) Applicant: Samsung Electronics Co., Ltd, Suwon-si, Gyeonggi-do 16677 (KR)
(72) Inventor: KWON, Junyoung, Suwon-si 16678 (KR); KIM, Changhyun, 16678 Suwon-si (KR); BYUN, Kyung-Eun, Suwon-si 16678 (KR); SEOL, Minsu, Suwon-si 16678 (KR)
(74) Representative: Elkington and Fife LLP

(57) **Abstract**

A semiconductor device includes a first channel layer (131) and a second channel layer (132) spaced from each other in a first direction (Z) and each include a two-dimensional (2D) semiconductor material, a first source electrode (151) between the first channel layer and the second channel layer to be simultaneously in contact with the first channel layer and the second channel layer, a first drain electrode (161) between the first channel layer and the second channel layer to be spaced apart from the first source electrode in a second direction (X) perpendicular to the first direction and simultaneously in contact with the first channel layer and the second channel layer, a first gate electrode (191) arranged in a first internal space surrounded by the first source electrode, the first drain electrode, the first channel layer, and the second channel layer, and a first gate insulating layer (171) surrounding the first gate electrode in the first internal space.

## Description

### FIELD OF THE INVENTION

Various non-limiting example embodiments relate, in general, to a semiconductor device and/or to a method of manufacturing the semiconductor device.

### BACKGROUND OF THE INVENTION

A transistor is a semiconductor device with an electrical switching function and is used in various integrated circuit devices including memory devices, driving integrated circuits (ICs), logic devices, etc. In order to improve the integration degree of an IC device, a spaced occupied by a transistor included therein has been rapidly reduced. As such, a channel length of the transistor is reduced, and/or thicknesses of layers forming the transistor are reduced as well.

Because silicon semiconductors are reaching limitations in physically reducing a gate length, a three-dimensional (3D) structure capable of increasing a direct contact area of a gate around the channel has been suggested in order to obtain an additional gate control.

Additionally or alternatively, interest in two-dimensional (2D) semiconductors, which are thin semiconductor materials with better gate control than silicon, has increased. A processing method of manufacturing a 3D transistor structure by using a 2D semiconductor material has been sought.

### SUMMARY OF THE INVENTION

Provided are a semiconductor device and/or a method of manufacturing the semiconductor device by using a two-dimensional (2D) semiconductor material.

Additional aspects will be set forth in part in the description which follows and, in part, will be apparent from the description, or may be learned by practice of the presented embodiments of the disclosure.

According to some example embodiments, provided is a semiconductor device including a first channel layer and a second channel layer arranged to be spaced apart in a first direction with the first channel layer including a first two-dimensional (2D) semiconductor material and the second channel layer including a second 2D semiconductor material that is the same as or different from the first 2D semiconductor material, a first source electrode between the first channel layer and the second channel layer to be simultaneously in contact with the first channel layer and the second channel layer, a first drain electrode between the first channel layer and the second channel layer to be spaced apart from the first source electrode in a second direction perpendicular to the first direction, and to be simultaneously in contact with the first channel layer and the second channel layer, a first gate electrode in a first internal space surrounded by the first source electrode, the first drain electrode, the first channel layer, and the second channel layer, and a first gate insulating layer surrounding the first gate electrode in the first internal space.

Alternatively or additionally according to various example embodiments, provided is an electronic apparatus including a semiconductor device, and a controller configured to control the semiconductor device, wherein the semiconductor device includes a first channel layer and a second channel layer arranged to be spaced in a first direction with the first channel layer including a first two-dimensional (2D) semiconductor material and the second channel layer including a second 2D semiconductor material the same as or different from the first 2D semiconductor material, a first source electrode between the first channel layer and the second channel layer to be simultaneously in contact with the first channel layer and the second channel layer, a first drain electrode between the first channel layer and the second channel layer to be spaced apart from the first source electrode in a second direction perpendicular to the first direction, and to be simultaneously in contact with the first channel layer and the second channel layer, a first gate electrode in a first internal space surrounded by the first source electrode, the first drain electrode, the first channel layer, and the second channel layer, and a first gate insulating layer surrounding the first gate electrode in the first internal space.

Alternatively or additionally according to various example embodiments, provided is a method of manufacturing a semiconductor device, including forming a first channel layer including a first two-dimensional (2D) semiconductor material, and forming a first source electrode and a first drain electrode that are in contact with the first channel layer and spaced apart from each other, forming a second channel layer in contact with the first source electrode and the first drain electrode, spaced apart from the first channel layer, and including a second 2D semiconductor material that is the same as or different from the first 2D semiconductor material, forming a first gate insulating layer conformally along inner walls of a first internal space surrounded by the first channel layer, the second channel layer, the first source electrode, and the first drain electrode, and forming a first gate electrode in a region surrounded by the first gate insulating layer in the first internal space.

### BRIEF DESCRIPTION OF THE DRAWINGS

The above and other aspects, features, and advantages of certain non-limiting example embodiments will be more apparent from the following description taken in conjunction with the accompanying drawings, in which:
FIG. 1 is a partially cut perspective view schematically showing a structure of a semiconductor device according to some example embodiments;
FIG. 2 is a cross-sectional view schematically showing a structure of a semiconductor device according to some example embodiments;
FIGS. 3A to 3J are diagrams for describing a method of manufacturing a semiconductor device, according to some example embodiments;
FIGS. 4A to 4D are diagrams for describing a method of manufacturing a semiconductor device, according to some example embodiments;
FIG. 5 is a cross-sectional transmission electron micrograph of a manufactured semiconductor device;
FIG. 6 is a schematic block diagram of a display driver integrated circuit (IC) (DDI) and a display apparatus including the DDI, according to some example embodiments;
FIG. 7 is a circuit diagram of a complementary metal oxide semiconductor (CMOS) inverter according to some example embodiments;
FIG. 8 is a circuit diagram of a CMOS static random-access memory (SRAM) device according to some example embodiments;
FIG. 9 is a circuit diagram of a CMOS NAND circuit according to some example embodiments;
FIG. 10 is a block diagram of an electronic apparatus according to some example embodiments; and
FIG. 11 is a block diagram of an electronic apparatus according to some example embodiments.

### DETAILED DESCRIPTION

Reference will now be made in detail to some embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list.

The disclosure will be described in detail below with reference to accompanying drawings. The embodiments of the disclosure are capable of various modifications and may be embodied in many different forms. In the drawings, like reference numerals denote like components, and sizes of components in the drawings may be exaggerated for convenience of explanation.

Hereinafter, it will be understood that when a layer, region, or component is referred to as being "above" or "on" another layer, region, or component, it may be in contact with and directly on the other layer, region, or component, and intervening layers, regions, or components may be present.

It will be understood that although the terms "first," "second," etc. may be used herein to describe various components, these components should not be limited by these terms. These components are only used to distinguish one component from another. These terms do not limit the fact that materials or structures of components are different from one another.

An expression used in the singular encompasses the expression of the plural unless it has a clearly different meaning in the context. It will be further understood that when a portion is referred to as "comprising" another component, the portion may not exclude another component but may further comprise another component unless the context states otherwise.

Also, the terms "... unit", "... module" used herein specify a unit for processing at least one function or operation, and this may be implemented with hardware or software or a combination of hardware and software.

The use of the term of "the above-described" and similar indicative terms may correspond to both the singular forms and the plural forms.

Also, the steps of all methods described herein may be performed in any suitable order unless otherwise indicated herein or otherwise clearly contradicted by context. Also, the use of all exemplary terms (for example, etc.) is only to describe a technical detail, and the scope of rights is not limited by these terms unless the context is limited by the claims.

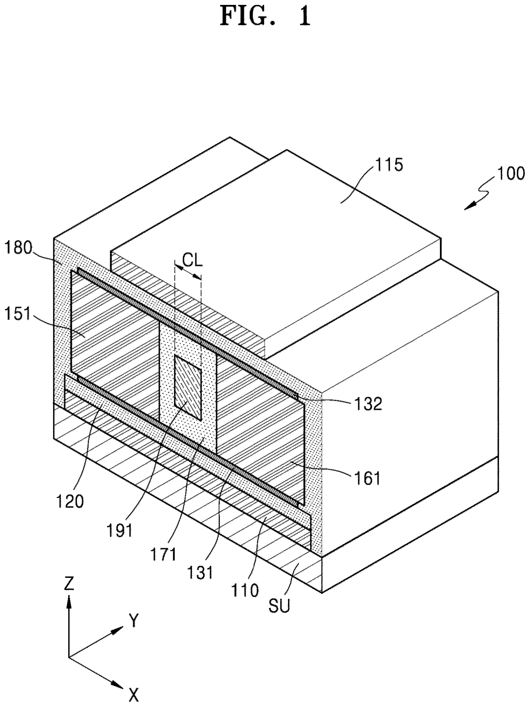

FIG. 1 is a partially cut perspective view schematically showing a structure of a semiconductor device 100 according to some example embodiments.

The semiconductor device 100 includes a first channel layer 131 and a second channel layer 132, which are spaced apart from each other, and a first source electrode 151 and a first drain electrode 161, which are arranged between the first channel layer 131 and the second channel layer 132 to be simultaneously in contact with the first channel layer 131 and the second channel layer 132, respectively. In some example embodiments, the first source electrode 151 may act as a drain electrode, and the first drain electrode may act as a source electrode; example embodiments are not limited thereto.

A first gate electrode 191 is arranged in an internal space surrounded by the first source electrode 151, the first drain electrode 161, the first channel layer 131, and the second channel layer 132, and a first gate insulating layer 171 surrounding the first gate electrode 191 is arranged.

A lower gate electrode 110 and a lower insulating layer 120 may be arranged under the first channel layer 131, and an upper insulating layer 180 and an upper gate electrode 115 may be arranged or at least partially arranged on the second channel layer 132. The lower gate electrode 110 may be formed on a substrate SU. The substrate SU may be a semiconductor substrate and may include, but is not limited to, one or more of silicon, germanium, silicon-germanium, oxide, nitride, etc.

The semiconductor device 100 according to various example embodiments uses a two-dimensional (2D) semiconductor material as a channel, and a structure in which the 2D semiconductor material is in surface-contact with the source and drain is provided.

Hereinafter, a detailed structure of the semiconductor device 100 is described below.

The first channel layer 131 and the second channel layer 132 are spaced apart from each other in a first direction (Z-direction). The first channel layer 131 and the second channel layer 132 each include, e.g., may consist of, a 2D semiconductor material. The first channel layer 131 may include the same 2D material as the second channel layer 132, and/or may include different materials than that of the second channel layer 132.

The 2D semiconductor material included in the first channel layer 131 and the second channel layer 132 may include one or more of a N-type 2D semiconductor such as one or more of MoS₂, MoSe₂, MoTe₂, WS₂, etc. and a P-type 2D semiconductor such as one or more of WSe₂, MoTe₂, PtSe₂, etc.

The first channel layer 131 and the second channel layer 132 may adopt various 2D semiconductor materials. For example, a transition metal dichalcogenides (TMD) material may be used as the 2D semiconductor material. The TMD may include a metal element selected from the group consisting of Mo, W, Nb, V, Ta, Ti, Zr, Hf, Tc, Re, Cu, Ga, In, Sn, Ge, and Pb and a chalcogen element selected from the group consisting of S, Se, and Te. Alternatively or additionally, one or more of graphene, black phosphorous, amorphous boron nitride, phosphorene, etc. may be used as the 2D semiconductor material.

The 2D semiconductor material may be doped, e.g., with a p-type dopant such as boron or an n-type dopant such as phosphorus and/or arsenic in order to adjust mobility. Here, for example, the p-type dopant and the n-type dopant used in the graphene, carbon nanotube (CNT), etc. may be used. The p-type dopant or the n-type dopant may be doped using an ion implantation or chemical doping method.

The 2D semiconductor material is used to implement a short channel length CL when the semiconductor device 100 is applied as a field-effect transistor. The channel length CL (or, physical channel length) denotes a length of a channel region in a direction in which a source electrode and a drain electrode are spaced apart from each other (X-direction), that is, as shown in FIG. 1, denotes a length of a first gate electrode 191 in the X-direction. The channel length has been reduced according to a miniaturization trend of electronic apparatuses. As the channel length become shorter, issues due to a short channel effect occur. It may be advantageous to reduce a thickness of the channel region in order to effectively reduce or help to reduce the channel length and to prevent or improve upon the above issues. To this end, the 2D semiconductor material is used in the first channel layer 131 and the second channel layer 132, and thus, a reduced or minimum channel length that may be implemented may be set, e.g., may be set as short as possible.

The 2D semiconductor material has excellent electrical properties, and thus, characteristics thereof are not largely changed and high mobility may be maintained even when a thickness is reduced to a nano-scale. The 2D semiconductor material may have a monolayer, trilayer, or multilayer structure. Each layer in the 2D semiconductor material may have a thickness of an atomic level (e.g., a single atomic layer thickness). The number of layers of the 2D semiconductor material adopted in the first channel layer 131 and the second channel layer 132 may be set in consideration of performance of the channel and a total thickness of the channel.

A thickness of the first channel layer 131 and the second channel layer 132 may be about 10 nm (100 Angstroms) or less, for example, 5 nm (50 Angstroms) or less, or 3 nm (30 Angstroms) or less. The thicknesses of the first channel layer 131 and the second channel layer 132 are not limited to the above example, and may be further reduced. A thickness of the first channel layer 131 may be the same as, or different from (thicker than or thinner than) a thickness of the second channel layer 132.

The channel length CL may be 10 nm or less, or 8 nm or less. Alternatively, the channel length CL may be 7 nm or less, 5 nm or less, or 3 nm or less. However, example embodiments are not limited thereto.

The first source electrode 151 and the first drain electrode 161 may be arranged so that lower surfaces of the first source electrode 151 and the first drain electrode 161 may come into contact with the first channel layer 131, and upper surfaces of the first source electrode 151 and the first drain electrode 161 may come into contact with the second channel layer 132.

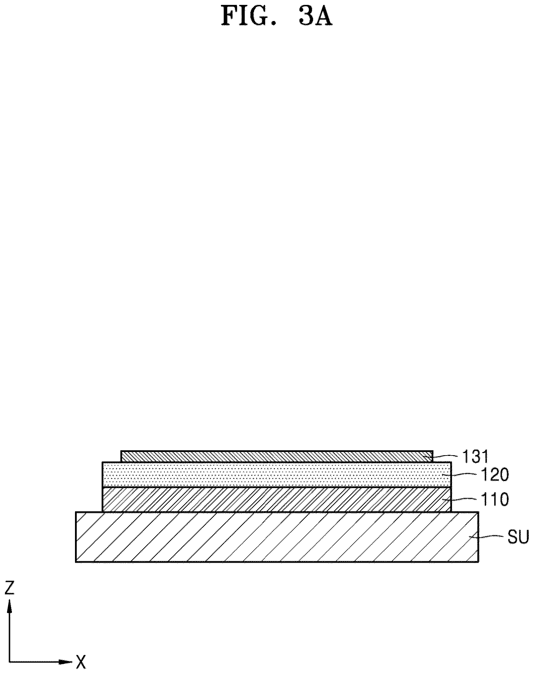

When the 2D semiconductor material is included in the first channel layer 131 and the second channel layer 132, it may not be easy for the 2D semiconductor material to electrically contact the first source electrode 151 and the first drain electrode 161 through general semiconductor manufacturing processes. The structure according to various example embodiments is provided so that the 2D semiconductor material may be electrically in contact with the first source electrode 151 and the first drain electrode 161 based on manufacturing processes that may be implemented. The manufacturing method therefor is described below with reference to FIG. 3A, etc.

According to the above arrangement of the first source electrode 151, the first drain electrode 161, the first channel layer 131, and the second channel layer 132, an internal space surrounded by the first source electrode 151, the first drain electrode 161, the first channel layer 131, and the second channel layer 132 may be defined, and the first gate insulating layer 171 and the first gate electrode 191 are arranged in the internal space.

The first gate insulating layer 171 may be conformally formed along the inner wall of the internal space surrounded by the first source electrode 151, the first drain electrode 161, the first channel layer 131, and the second channel layer 132, and the first gate electrode 191 may be formed in the space surrounded by the first gate insulating layer 171.

As described above, the first gate electrode 191 and a lower gate electrode 110 are respectively arranged on the upper and lower portions of the first channel layer 131, and an upper gate electrode 115 and the first gate electrode 191 are arranged on the upper and lower portions of the second channel layer 132. The first channel layer 131 and the second channel layer 132 include the 2D semiconductor material, and thus, the above arrangement may provide or be arranged substantially as a gate all around (GAA) structure.

The first gate insulating layer 171, the lower insulating layer 120, and the upper insulating layer 180 all act as gate insulating materials, and may independently include various insulating materials that may be used as gate insulating materials.

The insulating material may include a high-k dielectric material having high dielectric constant greater than that of silicon oxide, and may include aluminum oxide, hafnium oxide, zirconium oxide, lanthanum oxide, etc. However, one or more embodiments are not limited to the above example.

In some example embodiments, the insulating material may include a ferroelectric material; however, example embodiments are not limited thereto. The ferroelectric material has a spontaneous dipole (electric dipole), that is, a spontaneous polarization, in a crystallized material structure because the charge distribution in a unit cell is non-centrosymmetric. Thus, the ferroelectric material has a remnant polarization due to dipoles even when no external electric field is applied to the ferroelectric material. Alternatively or additionally, the direction of polarization may be switched on a domain basis by an external electric field. The ferroelectric material may include, for example, at least one oxide selected from hafnium (Hf), silicon (Si), aluminum (Al), zirconium (Zr), yttrium (Y), lanthanum (La), gadolinium (Gd), and strontium (Sr). However, these materials are examples. In addition, the ferroelectric material may further include a dopant as necessary.

When the ferroelectric material is used as the gate insulating material, the semiconductor device 100 may be or may correspond to a field-effect transistor that is applied to a logic device or a memory device. Because a subthreshold swing (SS) of the semiconductor device 100 may be lowered by the negative capacitance effect due to the ferroelectric material, the semiconductor device 100 may act as a field-effect transistor having improved performance and reduced size.

In some example embodiments, gate insulating material may have a multilayer structure including a high-k material and a ferroelectric material.

The materials in the first gate insulating layer 171, the lower insulating layer 120, and the upper insulating layer 180 may be the same as or different from one another. The materials included in the first gate insulating layer 171, the lower insulating layer 120, and the upper insulating layer 180 may be set respectively to be suitable for a detailed method for forming materials during manufacturing processes.

As shown in the drawings, the upper insulating layer 180 is arranged in a region between the second channel layer 132 and the upper gate electrode 115, and may extend to the side surfaces of the first source electrode 151 and the first drain electrode 161. However, example embodiments are not limited thereto.

The first gate electrode 191, the lower gate electrode 110, and the upper gate electrode 115 may independently include a metal material or a conductive oxide. Here, the metal material may include at least one selected from the group consisting of or including, for example, Au, Ti, TiN, TaN, W, Mo. WN, Pt, and Ni. The conductive oxide may include, for example, indium tin oxide (ITO), indium zinc oxide (IZO), etc.

The materials included in the first gate electrode 191, the lower gate electrode 110, and the upper gate electrode 115 may be the same as and/or different from one another. The materials included in the first gate electrode 191, the lower gate electrode 110, and the upper gate electrode 115 may be set respectively to be suitable for a detailed method for forming materials during manufacturing processes.

The first source electrode 151 and the first drain electrode 161 may include a metal material having good, e.g., excellent electric conductivity. For example, the first source electrode 151 and the first drain electrode 161 may each independently or concurrently include metal such as one or more of magnesium (Mg), aluminum (Al), scandium (Sc), titanium (Ti), vanadium (V), chrome (Cr), manganese (Mn), nickel (Ni), copper (Cu), zinc (Zn), gallium (Ga), zirconium (Zr), niobium (Nb), molybdenum (Mo), lead (Pd), argentum (Ag), cadmium (Cd), indium (In), tin (Sn), lanthanum (La), hafnium (Hf), tantalum (Ta), tungsten (W), iridium (Ir), platinum (Pt), aurum (Au), bismuth (Bi), etc., or an alloy thereof.

The substrate SU may include an insulating substrate, or a semiconductor substrate having an insulating layer formed on the surface thereof. The semiconductor substrate may include, for example, Si, Ge, SiGe, or group III-V semiconductor material. The substrate SU may include, for example, a silicon substrate having a silicon oxide formed on the surface thereof, but is not limited thereto. The substrate SU may be doped, or may be undoped.

The semiconductor device 100 includes a plurality of layers of channels including the 2D semiconductor material, and may actually have a GAA structure. FIG. 1 shows that the semiconductor device 100 includes two layers, for example, the first channel layer 131 and the second channel layer 132, but may include more layers.

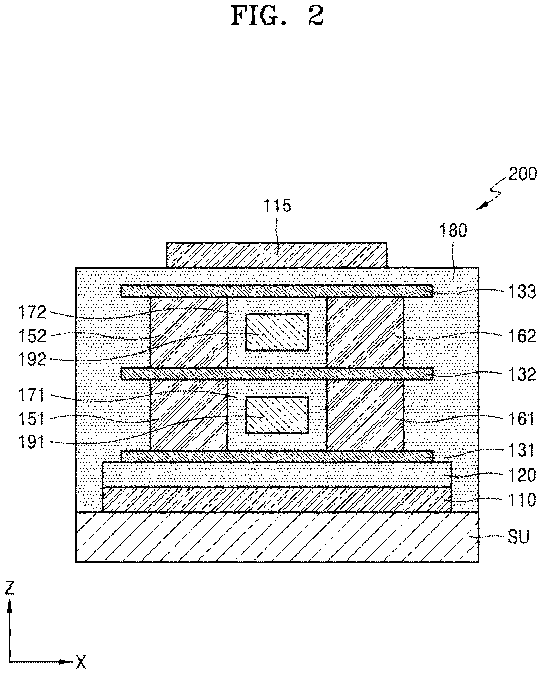

FIG. 2 is a cross-sectional view schematically showing a structure of a semiconductor device 200 according to some example embodiments.

The semiconductor device 200 differs from the semiconductor device 100 of FIG. 1 in view of a channel structure arranged in triple layers, and the difference is only described below.

A second source electrode 152 and a second drain electrode 162 are arranged on the second channel layer 132 to be spaced apart from each other. The second source electrode 152 and the second drain electrode 162 may be arranged to be in contact with the upper surface of the second channel layer 132. A third channel layer 133 may be arranged to be in contact with both the upper surface of the second source electrode 152 and the upper surface of the second drain electrode 162, at the same time.

According to the above arrangement of the second source electrode 152, the second drain electrode 162, the second channel layer 132, and the third channel layer 133, an internal space surrounded by the second source electrode 152, the second drain electrode 162, the second channel layer 132, and the third channel layer 133 may be defined, and a second gate insulating layer 172 and a second gate electrode 192 are arranged in the internal space.

The second gate insulating layer 172 may be formed, e.g., may be conformally formed, along the inner wall of the internal space surrounded by the second source electrode 152, the second drain electrode 162, the second channel layer 132, and the third channel layer 133, and then, the second gate electrode 192 may be formed in the space surrounded by the second gate insulating layer 172.

The method of manufacturing the semiconductor device according to various example embodiments includes forming a source electrode and a drain electrode that are in contact with a channel layer formed of a 2D semiconductor material, and after, forming two channel layers that are in contact with the source electrode and the drain electrode on the source electrode and the drain electrode. The above processes may be repeated a plurality of times. Next, gate insulating layers corresponding to the plurality of channel layers may be formed, and a plurality of gate electrodes may be also formed.

The method of manufacturing the semiconductor device according to various example embodiments is described in detail below.

FIGS. 3A to 3J are diagrams for describing a method of manufacturing a semiconductor device, according to some example embodiments.

Referring to FIG. 3A, the first channel layer 131 including a 2D semiconductor material is provisioned.

The first channel layer 131 may be formed on the lower insulating layer 120, and the lower insulating layer 120 may be formed on the lower gate electrode 110. The lower gate electrode 110 may be formed on a substrate SU.

The first channel layer 131 may be directly formed on the lower insulating layer 120, or may be manufactured on another substrate and then transferred onto the lower insulating layer 120.

The 2D semiconductor material included in the first channel layer 131 may be formed by, for example, one or more of a metal organic chemical vapor deposition (MOCVD) method, atomic layer deposition (ALD) method, etc. The first channel layer 131 may have a single or multi-layered structure including the 2D semiconductor material.

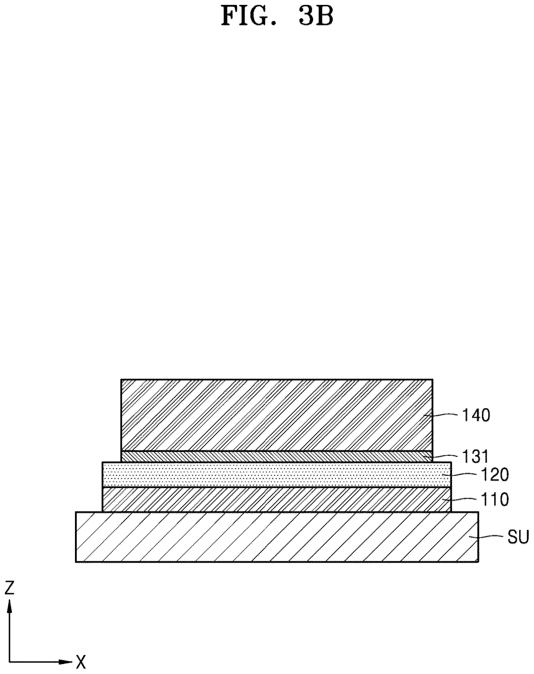

Referring to FIG. 3B, a metal material layer 140 is formed on the first channel layer 131. The metal material layer 140 may be formed by, for example, an electroless plating method and/or a sputtering method. However, example embodiments are not limited to the above example.

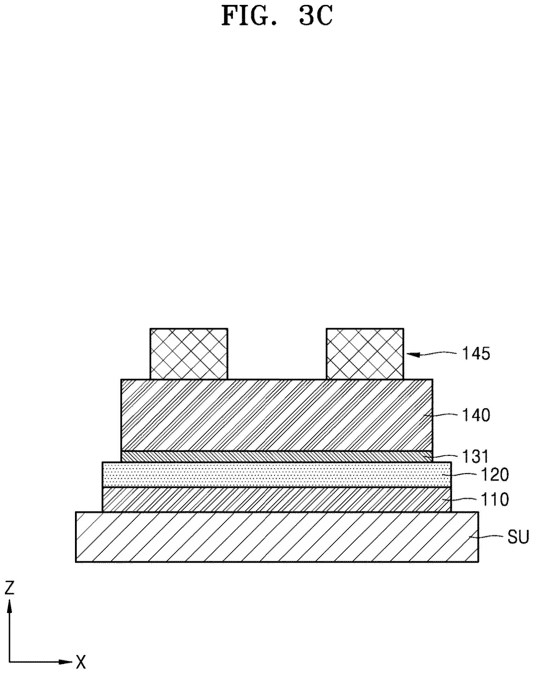

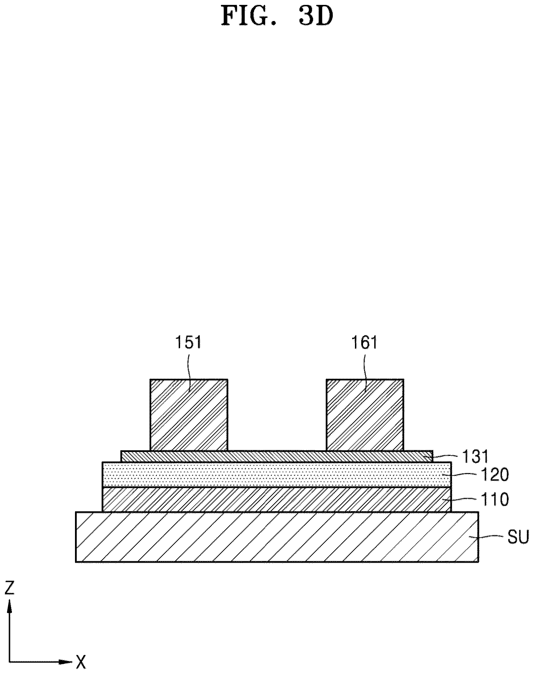

Referring to FIG. 3C, a mask pattern layer 145 for patterning the metal material layer 140 is formed. The mask pattern layer 145 may include, for example, a photoresist material, and may have a pattern corresponding to a source electrode and a drain electrode that are to be manufactured. An etching process using the mask pattern layer 145 as a mask may be performed. The etching process may include wet-etching and/or dry etching. After the etching process, when the mask pattern layer 145 is removed, as shown in FIG. 3D, the first source electrode 151 and the first drain electrode 161 are provided to be in contact with the upper surface of the first channel layer 131.

In FIGS. 3B to 3D, the process of forming the first source electrode 151 and the first drain electrode 161 is described as a photolithography process as an example, but one or more embodiments are not limited thereto, for example, a lift-off process and/or a damascene process may be used.

The lift-off process may include, for example, forming a mask layer having a pattern corresponding to an inverse shape of the first source electrode 151 and the first drain electrode 161 that are to be formed on the first channel layer 131, and forming a metal material layer entirely on the first channel layer 131 provided with the mask layer. Next, when the mask layer is removed, the metal material on the mask layer is also removed, and the structure shown in FIG. 3D may be provided.

The damascene process may include, for example, forming an oxide layer on the first channel layer 131, and then patterning the oxide layer so that the portions to be in contact with the first source electrode and the first drain electrode are opened. Next, a metal material layer is formed on the first channel layer 131 to a thickness that may entirely cover the patterned oxide layer and a chemical mechanical polishing (CMP) process may be performed.

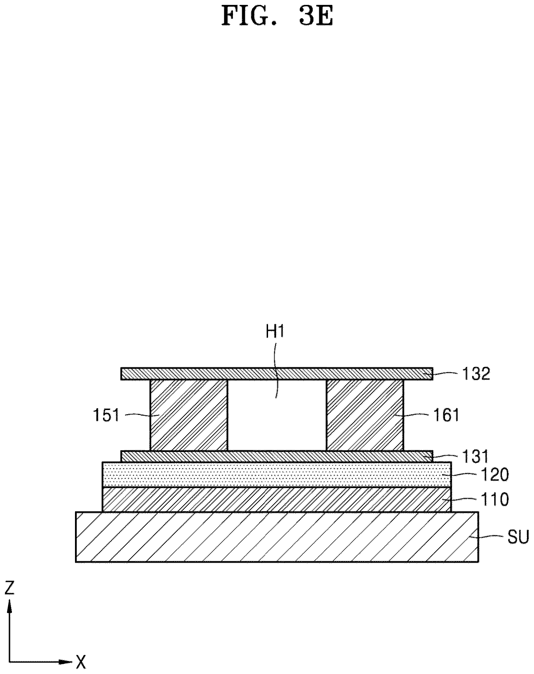

Referring to FIG. 3E, the second channel layer 132 is formed on the first source electrode 151 and the first drain electrode 161. The second channel layer 132 may include one or more 2D semiconductor materials that is the same as and/or different from 2D semiconductor materials included in the first channel layer 131.. The second channel layer 132 is formed to be suspended between the first source electrode 151 and the first drain electrode 161, and may be formed by transferring a 2D film that is separately manufactured. Accordingly, a first internal space H1 surrounded by the first channel layer 131, the first source electrode 151, the first drain electrode 161, and the second channel layer 132 may be formed.

Sizes of the first source electrode 151 and the first drain electrode 161 may be appropriately set so that the second channel layer 132 is in contact with the first source electrode 151 and the first drain electrode 161 and may be suspended between the first source electrode 151 and the first drain electrode 161. For example, a sum of the lengths of the first source electrode 151 and the first drain electrode 161 in the transverse direction (X-direction) may be greater than the length of the first internal space H1 in the transverse direction (X-direction).

The length of the second channel layer 132, for example, the length in the direction (X-direction) in which the first source electrode 151 and the first drain electrode 161 are spaced apart from each other, may be similar to the length (reference length) from a left end of the first source electrode 151 to a right end of the first drain electrode 161, or may be greater or less than the reference length. The length of the second channel layer 132 may be, for example, about 90% to about 110% of the reference length. However, example embodiments are not limited thereto, and the lengths shown in the drawings are examples.

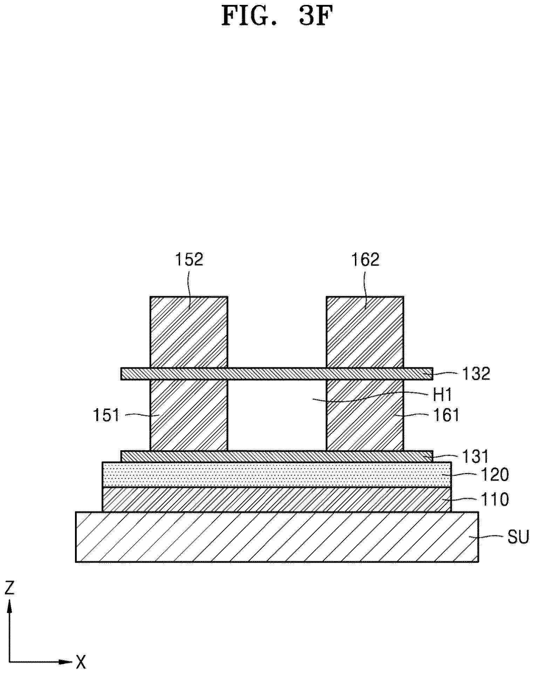

Referring to FIG. 3F, the second source electrode 152 and the second drain electrode 162 are formed on the second channel layer 132. The processes of forming the second source electrode 152 and the second drain electrode 162 may be similar to the processes of forming the first source electrode 151 and the first drain electrode 161 on the first channel layer 131; however, example embodiments are not limited thereto. A thickness of the second source electrode 152 and of the second drain electrode 162 may be the same as, or greater than, or less than a thickness of the first source electrode 151 and the first drain electrode 161.

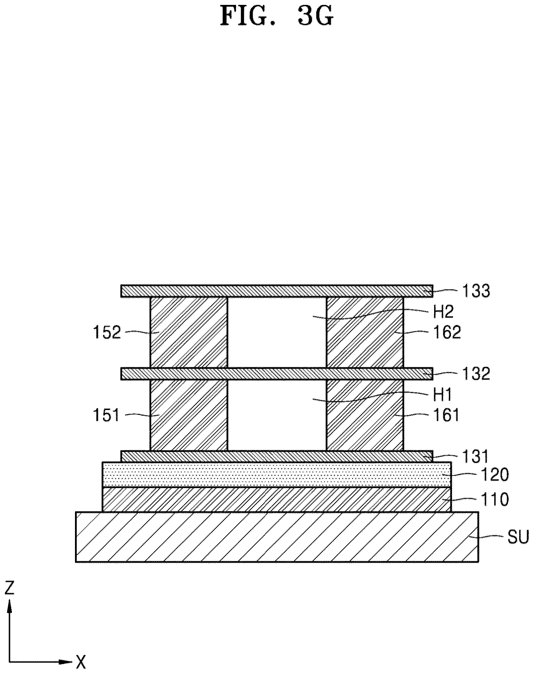

Referring to FIG. 3G, the third channel layer 133 is formed on the second source electrode 152 and the second drain electrode 162.

The third channel layer 133 includes a 2D semiconductor material. Similarly to the second channel layer 132, the third channel layer 133 may be formed through a transfer process of a 2D film, and may be formed to be suspended between the second source electrode 152 and the second drain electrode 162 while being in contact with the upper portions of the second source electrode 152 and the second drain electrode 162. Accordingly, a second internal space H2 surrounded by the second channel layer 132, the second source electrode 152, the second drain electrode 162, and the third channel layer 133 may be formed.

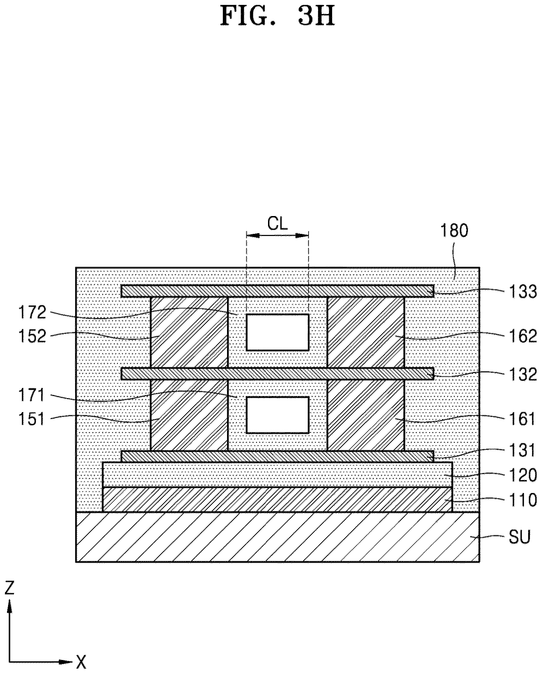

An insulating material may be formed conformally on the inner wall of the first internal space H1 and the inner wall of the second internal space H2, and as shown in FIG. 3H, the first gate insulating layer 171 and the second gate insulating layer 172 may be formed. For example, the first gate insulating layer 171 and the second gate insulating layer 172 may be simultaneously formed through the same manufacturing process. The first gate insulating layer 171 and the second gate insulating layer 172 may include the same insulating material. The first gate insulating layer 171 and the second gate insulating layer 172 may be formed by the ALD method. However, one or more embodiments are not limited to the above example.

During the process of forming the first gate insulating layer 171 and the second gate insulating layer 172, the upper insulating layer 180 may be at least partially formed. The upper insulating layer 180 may cover the upper surface of the third channel layer 133, and may be formed to extend to the side portions of the first source electrode 151, the first drain electrode 161, the second source electrode 152, and the second drain electrode 162.

Two spaces respectively surrounded by the first gate insulating layer 171 and the second gate insulating layer 172 are locations where a first gate electrode and a second gate electrode are to be formed. The thicknesses of the first gate insulating layer 171 and the second gate insulating layer 172 may be determined in consideration of the channel length CL of the channel to be formed.

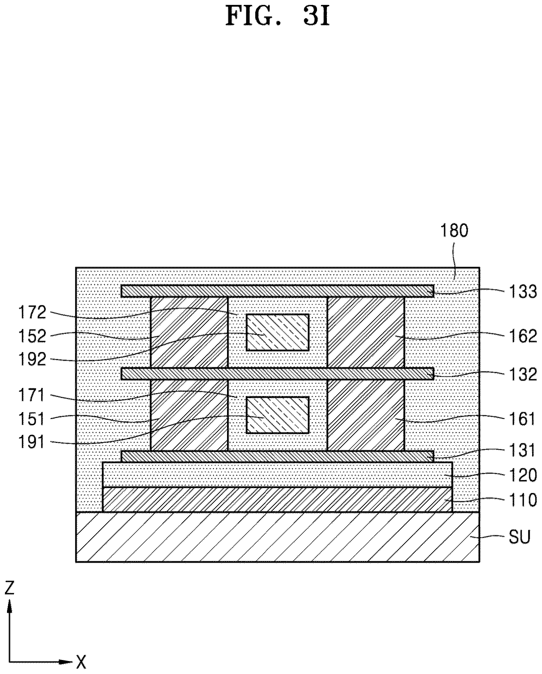

Referring to FIG. 3I, the first gate electrode 191 surrounded by the first gate insulating layer 171 and the second gate electrode 192 surrounded by the second gate insulating layer 172 are formed. The first gate electrode 191 and the second gate electrode 192 may be formed by the ALD method and/or a plasma enhanced CVD (PECVD) process, but are not limited thereto.

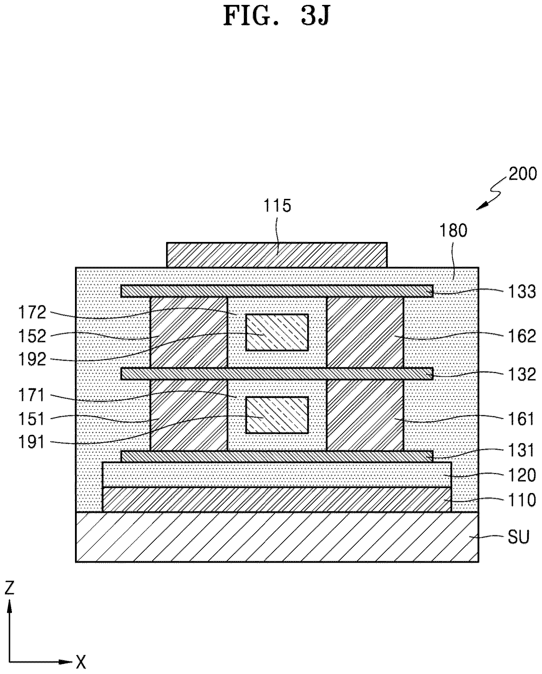

Referring to FIG. 3J, the upper gate electrode 115 is formed on the upper insulating layer 180.

The semiconductor device 200 manufactured above has a triple-layered structure, including the first channel layer 131, the second channel layer 132, and the third channel layer 133, as shown in FIG. 2 is shown as an example, but one or more embodiments are not limited thereto.

For example, in FIG. 3E, the first gate insulating layer 171 and the first gate electrode 191 may be formed to manufacture the semiconductor device 100 as shown in FIG. 1.

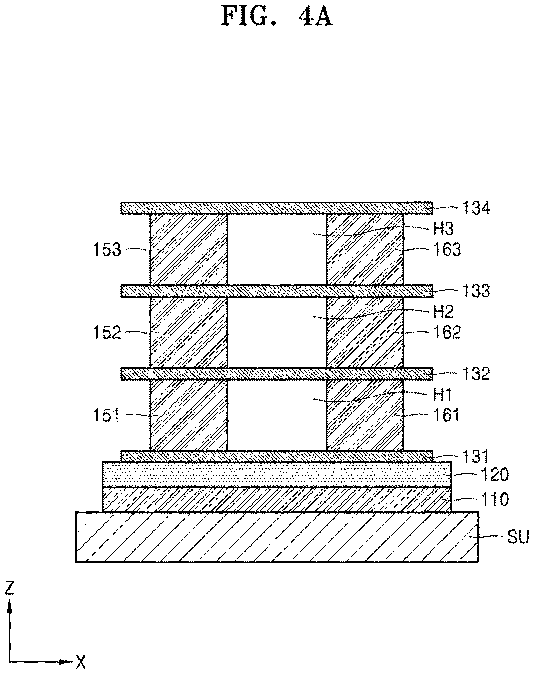

FIGS. 4A to 4D are diagrams for describing a method of manufacturing a semiconductor device, according to some example embodiments.

Referring to FIG. 4A, in an additional process to the process of FIG. 3G, a third source electrode 153 and a third drain electrode 163 are formed on the third channel layer 133, and a fourth channel layer 134 may be formed on the third source electrode 153 and the third drain electrode 163.

As described above, a first internal space H1 surrounded by the first channel layer 131, the first source electrode 151, the first drain electrode 161, and the second channel layer 132, a second internal space H2 surrounded by the second channel layer 132, the second source electrode 152, the second drain electrode 162, and the third channel layer 133, and a third internal space H3 surrounded by the third channel layer 133, the third source electrode 153, the third drain electrode 163, and the fourth channel layer 134 may be provided.

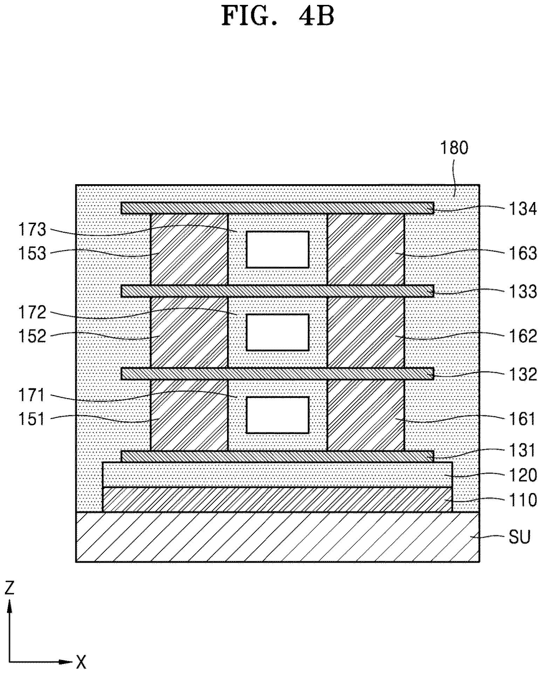

An insulating material is conformally applied to inner walls in each of the first to third internal spaces H1, H2, and H3, and thus, as shown in FIG. 4B, the first gate insulating layer 171, the second gate insulating layer 172, and the third gate insulating layer 173 may be formed. The first gate insulating layer 171, the second gate insulating layer 172, and the third gate insulating layer 173 may be simultaneously formed in the same process. In addition, at least a part of the upper insulating layer 180 may be formed. The size (e.g., the length and/or width) of each of the first through third internal spaces H1, H2, and H3 may be the same as, or different from, each other.

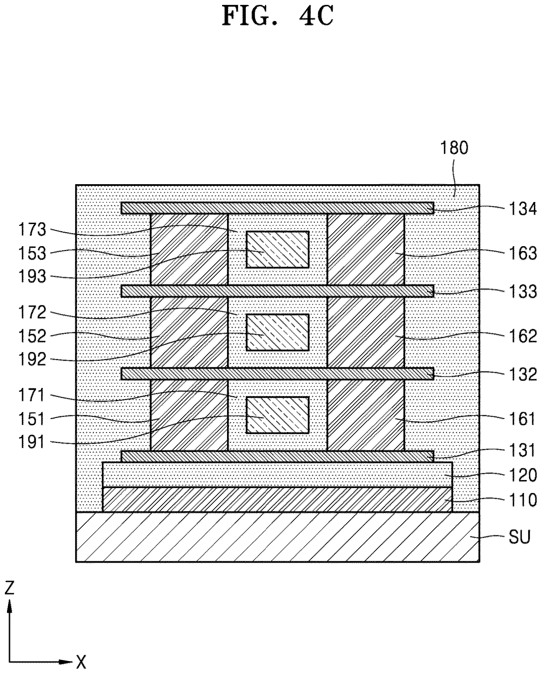

Referring to FIG. 4C, the first gate electrode 191, the second gate electrode 192, and the third gate electrode 193 may be formed respectively in the spaces surrounded by the first gate insulating layer 171, the second gate insulating layer 172, and the third gate insulating layer 173.

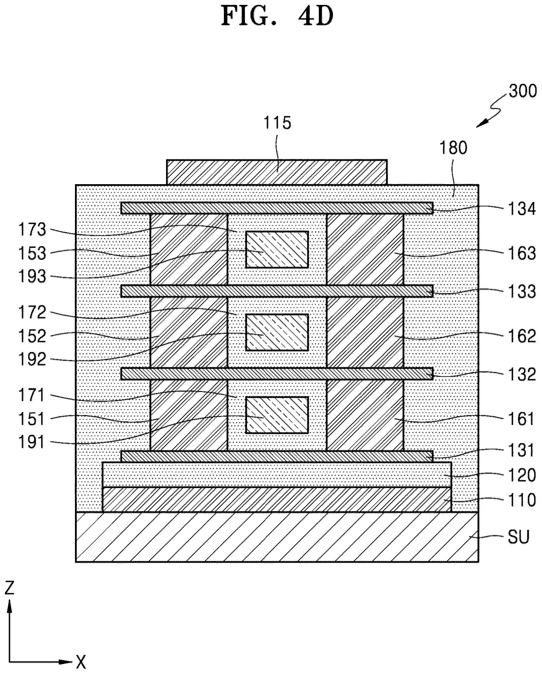

Referring to FIG. 4D, the upper gate electrode 115 is formed on the upper insulating layer 180, and thus, a semiconductor device 300 having a substantial GAA structure and four channel layers is provided.

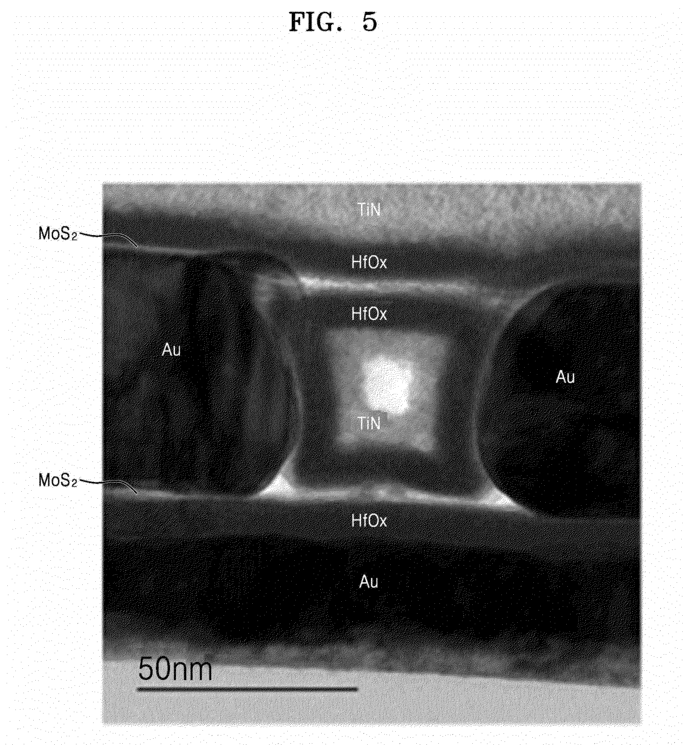

FIG. 5 is a cross-sectional transmission electron micrograph of a manufactured semiconductor device.

A structure in which a 2D semiconductor material MoS₂ is well in contact with each of the upper and lower surfaces of the source electrode and the drain electrode materials is identified.

The semiconductor device according to various example embodiments and the semiconductor device provided according to the manufactured method of various example embodiments may show improved, e.g., excellent electric performance with ultra small structure and may be applied to an integrated circuit device. The semiconductor device according to various example embodiments may be utilized as a logic transistor and may be applied to various electronic apparatuses along with a controller controlling the logic transistor.

The semiconductor devices 100, 200, and 300 described above may be used in, for example, one or more of a driving integrated circuit of a display, a complementary metal oxide semiconductor (CMOS) inverter, a CMOS SRAM device, a CMOS NAND circuit, and/or other various electronic apparatuses.

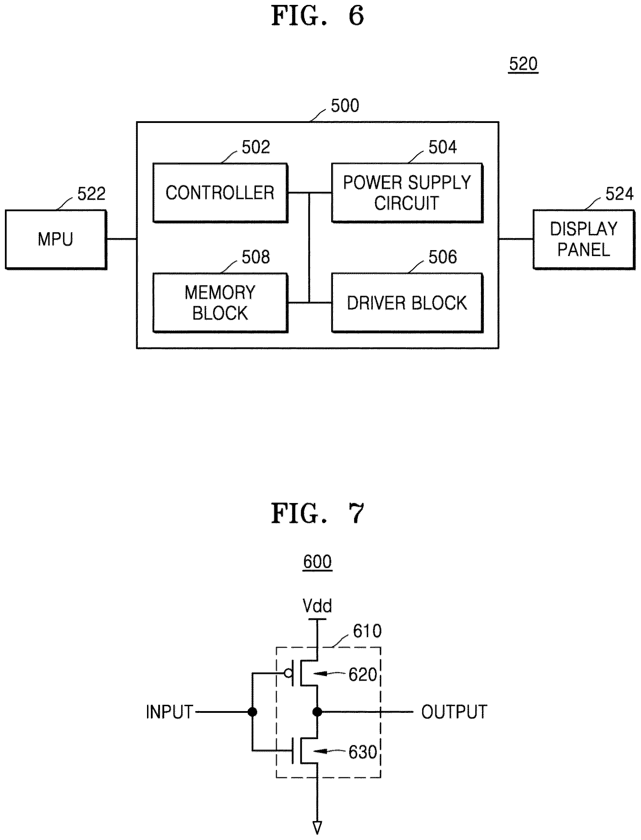

FIG. 6 is a schematic block diagram of a display driver integrated circuit (IC) (DDI) 500 and a display apparatus including the DDI, according to some example embodiments.

Referring to FIG. 6, the DDI 500 may include a controller 502, a power supply circuit 504, a driver block 506, and a memory block 508. The controller 502 receives and decodes commands applied from a main processing unit (MPU) 522, and controls each block in the DDI 500 for implementing operations according to the commands. The power supply circuit 504 generates a driving voltage in response to the control from the controller 502. The driver block 506 drives a display panel 524 by using the driving voltage that is generated by the power supply circuit 504 in response to the control from the controller 502. The display panel 524 may include, for example, a liquid crystal display panel, an organic light-emitting device (OLED) panel, or a plasma display panel. The memory block 508 is a block for temporarily storing commands input to the controller 502 or control signals output from the controller 502, and/or for storing required or used data, and may include a memory such as one or more of RAM, ROM, etc. The power supply circuit 504 and the driver block 506 may each include one of the semiconductor devices 100, 200, and 300 according to various example embodiments described above with reference to FIGS. 1 to 4D, or a semiconductor device modified and combined therefrom.

FIG. 7 is a circuit diagram of a CMOS inverter 600 according to some example embodiments.

Referring to FIG. 7, the CMOS inverter 600 includes a CMOS transistor 610. The CMOS transistor 610 includes a PMOS transistor 620 and an NMOS transistor 630 connected between a power terminal Vdd and a ground terminal. The CMOS transistor 610 may include one or more of the semiconductor devices 100, 200, and 300 according to various example embodiments described above with reference to FIGS. 1 to 4D, or a semiconductor device modified and combined therefrom. Either or both of the PMOS transistor 620 and the NMOS transistor 630 may be implemented according to one or more of the semiconductor devices 100, 200, and 300.

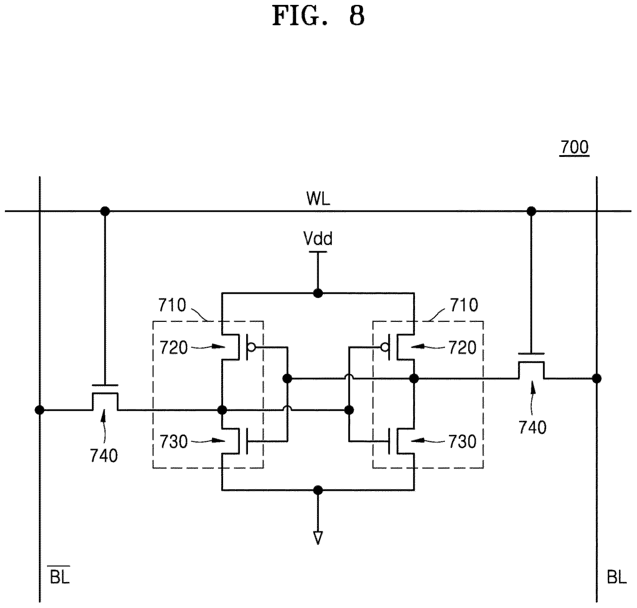

FIG. 8 is a circuit diagram of a CMOS SRAM device 700 according to some example embodiments.

Referring to FIG. 8, the CMOS SRAM device 700 includes a pair of driving transistors 710. The pair of transistors 710 each include a PMOS transistor 720 and an NMOS transistor 730 connected between the power terminal Vdd and the ground terminal. The CMOS SRAM device 700 may further include a pair of transfer transistors 740. Sources of the transfer transistors 740 may be cross-connected to common nodes of the PMOS transistor 720 and the NMOS transistor 730 forming the driving transistor 710. The power terminal Vdd is connected to a source of the PMOS transistor 720 and the ground terminal is connected to a source of the NMOS transistor 730. A word line WL may be connected to gates of the pair of transfer transistor 740, and a bit line BL and an inverted bit line may be respectively connected to drains of the pair of transfer transistors 740. At least one of the driving transistor 710 and the transfer transistor 740 of the CMOS SRAM device 700 may include one of the semiconductor devices 100, 200, and 300 according to various example embodiments described above with reference to FIGS. 1 to 4D, or a semiconductor device modified and combined therefrom.

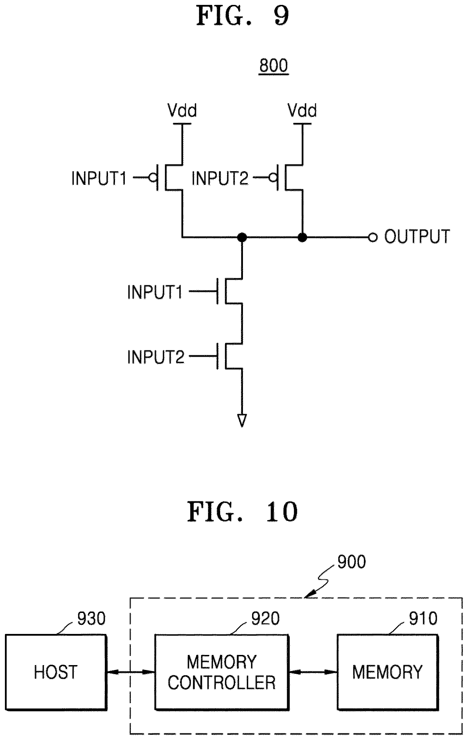

FIG. 9 is a circuit diagram of a CMOS NAND circuit 800 according to some example embodiments.

Referring to FIG. 9, the CMOS NAND circuit 800 may include a pair of CMOS transistors to which different input signals are transferred. The CMOS NAND circuit 800 may include one of the semiconductor devices 100, 200, and 300 according to various example embodiments described above with reference to FIGS. 1 to 4D, or a semiconductor device modified and combined therefrom.

FIG. 10 is a block diagram of an electronic apparatus 900 according to some example embodiments.

Referring to FIG. 10, the electronic apparatus 900 includes a memory 910 and a memory controller 920. The memory controller 920 may control the memory 910 in response to a request from a host 930, for reading and/or writing data from/into the memory 910. At least one of the memory 910 and the memory controller 920 may include one of the semiconductor devices 100, 200, and 300 according to various example embodiments described above with reference to FIGS. 1 to 4D, or a semiconductor device modified and combined therefrom.

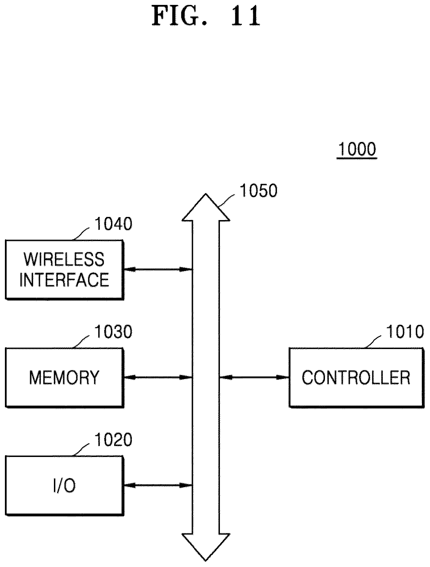

FIG. 11 is a block diagram of an electronic apparatus 1000 according to some example embodiments.

Referring to FIG. 11, the electronic apparatus 1000 may configure a wireless communication device or a device capable of transmitting and/or receiving information under wireless environment. The electronic apparatus 1000 includes a controller 1010, an input/output device (I/O) 1020, a memory 1030, and a wireless interface 1040, which are connected to one another via a bus 1050.

The controller 1010 may include one or more of a microprocessor, a digital signal processor, or at least one of similar processing devices. The I/O 1020 may include at least one of a keypad, a keyboard, and a display. The memory 1030 may be used to store commands executed by the controller 1010. For example, the memory 1030 may be used to store user data. The electronic apparatus 1000 may use the wireless interface 1040 for transmitting/receiving data via a wireless communication network. The wireless interface 1040 may include an antenna and/or a wireless transceiver. In some embodiments, the electronic apparatus 1000 may be used in a communication interface protocol of a third-generation communication system, for example, one or more of code division multiple access (CDMA), global system for mobile communication (GSM), north American digital cellular (NADC), extended-time division multiple access (E-TDMA), and/or wide band code division multiple access (WCDMA). The electronic apparatus 1000 may include at least one of the semiconductor devices 100, 200, and 300 according to various example embodiments described above with reference to FIGS. 1 to 4D, or a semiconductor device modified and combined therefrom.

The semiconductor device described above may implement a GAA structure by using a 2D semiconductor material.

The semiconductor device may be applied to various electronic apparatuses as a logic transistor.

According to the method of manufacturing the semiconductor device as described above, the semiconductor device having improved or excellent contact performances between the 2D semiconductor channel and the source/drain electrodes may be provided.

Any of the elements and/or functional blocks disclosed above may include or be implemented in processing circuitry such as hardware including logic circuits; a hardware/software combination such as a processor executing software; or a combination thereof. For example, the processing circuitry more specifically may include, but is not limited to, a central processing unit (CPU), an arithmetic logic unit (ALU), a digital signal processor, a microcomputer, a field programmable gate array (FPGA), a System-on-Chip (SoC), a programmable logic unit, a microprocessor, application-specific integrated circuit (ASIC), etc. The processing circuitry may include electrical components such as at least one of transistors, resistors, capacitors, etc. The processing circuitry may include electrical components such as logic gates including at least one of AND gates, OR gates, NAND gates, NOT gates, etc.

When the terms "about" or "substantially" are used in this specification in connection with a numerical value, it is intended that the associated numerical value includes a manufacturing or operational tolerance (e.g., ±10%) around the stated numerical value. Moreover, when the words "generally" and "substantially" are used in connection with geometric shapes, it is intended that precision of the geometric shape is not required but that latitude for the shape is within the scope of the disclosure. Moreover, when the words "generally" and "substantially" are used in connection with material composition, it is intended that exactitude of the material is not required but that latitude for the material is within the scope of the disclosure.

Further, regardless of whether numerical values or shapes are modified as "about" or "substantially," it will be understood that these values and shapes should be construed as including a manufacturing or operational tolerance (e.g., ±10%) around the stated numerical values or shapes. Thus, while the term "same," "identical," or "equal" is used in description of example embodiments, it should be understood that some imprecisions may exist. Thus, when one element or one numerical value is referred to as being the same as another element or equal to another numerical value, it should be understood that an element or a numerical value is the same as another element or another numerical value within a desired manufacturing or operational tolerance range (e.g., ±10%).

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

## Claims

1. A semiconductor device comprising:
a first channel layer and a second channel layer spaced apart from each other in a first direction, the first channel layer including a first two-dimensional (2D) semiconductor material and the second channel layer including a second 2D semiconductor material, the second 2D material the same as or different from the first 2D semiconductor material;
a first source electrode between the first channel layer and the second channel layer to be simultaneously in contact with the first channel layer and the second channel layer;
a first drain electrode between the first channel layer and the second channel layer to be spaced apart from the first source electrode in a second direction that is perpendicular to the first direction and to be simultaneously in contact with the first channel layer and the second channel layer;
a first gate electrode in a first internal space surrounded by the first source electrode, the first drain electrode, the first channel layer, and the second channel layer; and
a first gate insulating layer surrounding the first gate electrode in the first internal space.

2. The semiconductor device of claim 1, further comprising:
a lower gate electrode; and
a lower insulating layer between the lower gate electrode and the first channel layer.

3. The semiconductor device of claim 1 or 2, further comprising:
an upper gate electrode; and
an upper insulating layer between the upper gate electrode and the second channel layer.

4. The semiconductor device of any preceding claim, further comprising:
a third channel layer spaced apart from the second channel layer in the first direction and including a third 2D semiconductor material, the third 2D semiconductor material the same as or different from the first 2D semiconductor material and the same as or different from the first 2D semiconductor material, and optionally further comprising:
a second source electrode between the second channel layer and the third channel layer to be simultaneously in contact with the second channel layer and the third channel layer;
a second drain electrode between the second channel layer and the third channel layer to be spaced apart from the source electrode in a second direction that is perpendicular to the first direction and to be simultaneously in contact with the second channel layer and the third channel layer;
a second gate electrode in a second internal space surrounded by the second source electrode, the second drain electrode, the second channel layer, and the third channel layer; and
a second gate insulating layer surrounding the second gate electrode in the second internal space.

5. The semiconductor device of any preceding claim, wherein the first 2D semiconductor material includes one or more of MoS₂, MoSe₂, MoTe₂, WS₂, WSe₂, MoTe₂, or PtSe₂, and the second 2D semiconductor material includes one or more of MoS₂, MoSe₂, MoTe₂, WS₂, WSe₂, MoTe₂, or PtSe₂.

6. The semiconductor device of any preceding claim, wherein either or both the first 2D semiconductor material and the second 2D semiconductor material includes a metal element selected from among Mo, W, Nb, V, Ta, Ti, Zr, Hf, Tc, Re, Cu, Ga, In, Sn, Ge, and Pb and a chalcogen element selected from among S, Se, and Te.

7. The semiconductor device of any preceding claim, wherein the first channel layer and the second channel layer each independently include a double or triple-layered structure including the respective first or second 2D semiconductor material.

8. The semiconductor device of any preceding claim, wherein the first channel layer and the second channel layer each independently have a thickness of 3 nm or less.

9. The semiconductor device of any preceding claim, wherein a length of the first gate electrode in a direction in which the first source electrode and the first drain electrode are spaced apart from each other is 10 nm or less.

10. An electronic apparatus comprising:
a semiconductor device according to any preceding claim; and
a controller configured to control the semiconductor device.

11. A method of manufacturing a semiconductor device, the method comprising:
forming a first channel layer including a first two-dimensional, 2D, semiconductor material;
forming a first source electrode and a first drain electrode in contact with the first channel layer and spaced apart from each other;
forming a second channel layer contact with the first source electrode and the first drain electrode, spaced apart from the first channel layer, and includes a second 2D semiconductor material that is the same as or different from the first 2D semiconductor material;
conformally forming a first gate insulating layer along inner walls of a first internal space surrounded by the first channel layer, the second channel layer, the first source electrode, and the first drain electrode; and
forming a first gate electrode in a region surrounded by the first gate insulating layer in the first internal space.

12. The method of claim 11, wherein the second channel layer is formed to be suspended between the first source electrode and the first drain electrode by transferring a 2D film that is separately manufactured.

13. The method of claim 11 or 12, further comprising:
forming an upper insulating layer on the second channel layer; and
forming an upper gate electrode on the upper insulating layer, and optionally wherein the upper insulating layer and the first gate insulating layer are simultaneously formed in a same processing step.

14. The method of claim any of claims 11 to 13, further comprising:
forming a second source electrode and a second drain electrode that are in contact with the second channel layer and spaced apart from each other; and
forming a third channel layer that is in contact with the second source electrode and the second drain electrode, is spaced apart from the second channel layer, and includes a third 2D semiconductor material that is the same as or different from the first 2D semiconductor material and the second 2D semiconductor material, and optionally further comprising:
forming a second gate insulating layer conformally along inner walls of a second internal space surrounded by the second channel layer, the third channel layer, the second source electrode, and the second drain electrode; and
forming a second gate electrode in a region surrounded by the second gate insulating layer in the second internal space.

15. The method of claim 14, wherein the first gate insulating layer and the second gate insulating layer are formed simultaneously in a same processing step.
